# EUROPÄISCHE PATENTSCHRIFT

(11) **EP 2 440 025 B1**
(45) Veröffentlichungstag und Bekanntmachung des Hinweises auf die Patenterteilung: **03.05.2017**
(21) Anmeldenummer: 11180152.8
(22) Anmeldetag: 06.09.2011
(51) Int. Cl.: H05K 5/06, H05K 1/02, B81C 1/00, H01L 23/10

(54) **Abdeckeinrichtung für ein organisches Substrat, Substrat mit einer Abdeckeinrichtung und Verfahren zur Herstellung einer Abdeckeinrichtung**
Covering device for an organic substrate, substrate with a covering device, and method for producing a covering device
Dispositif de recouvrement pour un substrat organique, substrat doté d'un dispositif de recouvrement et procédé de fabrication d'un dispositif de recouvrement

(30) Priorität: 08.10.2010 US 391086 P
(43) Veröffentlichungstag der Anmeldung: 11.04.2012
(73) Patentinhaber: Dyconex AG, 8303 Bassersdorf (CH)
(72) Erfinder: Hauer, Marc, 8050 Zürich (CH)
(74) Vertreter: Galander, Marcus

(56) Entgegenhaltungen:
- WO-A2-2004/106221
- WO-A2-2010/081801
- US-A1- 2004 108 588
- US-A1- 2007 172 991

## Beschreibung

Die Erfindung betrifft eine Abdeckeinrichtung für ein organisches Substrat und ein Verfahren zur Herstellung einer Abdeckeinrichtung nach den Oberbegriffen der unabhängigen Patentansprüche.

Es ist bekannt, Schaltungen oder Bauteile auf Substraten, z.B. Leiterplatten, mit einem Gehäuse zu versehen. Dabei kann, insbesondere auf organischen Substraten, eine Verschlusskappe über der Schaltung oder dem Bauteil angeordnet werden und mittels Ultraschallschweißen, Löten oder Kleben auf dem Substrat fixiert werden.

Bei den bekannten Verfahren kann es jedoch zu Beschädigungen des organischen Substrats kommen, etwa durch einen hohen Energieeintrag beim Ultraschallschweißen. Um ein Lötverfahren auszuführen, muss die Verschlusskappe metallisiert werden oder aus Metall bestehen. Das Lot muss so ausgewählt werden, dass die Löttemperatur hoch genug für Folgeprozesse ist, denen das Substrat noch unterzogen werden soll, und andererseits niedrig genug ist, um das Substrat nicht zu beschädigen. Außerdem muss das Lot durch geeignete Mittel, etwa Laser oder Lötkolben, erhitzt werden.

Bei Klebeprozessen ist der Kleber in den Aufbau mit einzubringen. Die Herstellung einer hermetisch dichten Verbindung ist mit Klebeprozessen kritisch.

Die Verbindung einer Verschlusskappe mit einem Substrat durch lokales Aufschmelzen eines Dichtmittels ist aus den Dokumenten US 2007/172991 A1 und WO 2004/106221 A2 bekannt. Weiterhin sind aus den Dokumenten US 2004/108588 A1 und WO 2010/081801 A2 Verfahren zur Verbindung einer Kappe mit einem Substrat durch lokales Aufschmelzen von Plastikmaterialien mittels Laserstrahlen bekannt.

Der Erfindung liegt die Aufgabe zugrunde, eine Abdeckeinrichtung zu schaffen, die eine möglichst dichte Verbindung zwischen einer Verschlusskappe und einem organischen Substrat erlaubt und gleichzeitig die thermische Belastung für das Substrat und die zu schützenden Komponenten gering hält.

Eine weitere Aufgabe besteht darin, ein organisches Substrat anzugeben, die eine möglichst dichte Verbindung zwischen Verschlusskappe und dem Substrat erlaubt und gleichzeitig die thermische Belastung von Substrat und Bauteilen gering hält.

Eine weitere Aufgabe ist darin zu sehen, ein Verfahren anzugeben, mit dem eine möglichst dichte Verbindung zwischen Verschlusskappe und organischem Substrat bei gleichzeitig geringer thermischer Belastung von Substrat und Bauteilen möglich ist.

Die Aufgaben werden erfindungsgemäß durch die Merkmale der unabhängigen Patentansprüche gelöst. Günstige Ausgestaltungen und Vorteile der Erfindung ergeben sich aus den weiteren Ansprüchen, der Zeichnung und der Beschreibung.

Gemäß einem ersten Aspekt geht die Erfindung aus von einer Abdeckeinrichtung zum Abdecken eines Bereichs eines organischen Substrates, mit einer Verbindungszone zwischen einer Verschlusskappe und des organischen Substrates.

Es wird vorgeschlagen, dass die Verbindungszone wenigstens bereichsweise ein Heizelement zum Erwärmen der Verbindungszone bei der Herstellung einer Verbindung zwischen Verschlusskappe und Substrat umfasst.

Das Herstellen der Verbindung kann durch gezieltes lokales Aufschmelzen von vorgesehenen Bereichen der Verschlusskappe und des Substrats erfolgen und/oder durch Aufschmelzen eines Lots zwischen der Verschlusskappe und dem Substrat und/oder durch thermisches Aktivieren eines Klebers zwischen der Verschlusskappe und dem Substrat. Dabei kann das Heizelement insbesondere pulsweise betrieben werden. Damit kann gezielt lokal eine hohe Temperatur erreicht werden, ohne weiter vom Heizelement entfernte Bereiche des Substrats unnötig stark thermisch zu belasten.

Ein solches Aufschmelzen ist auch als Joulsche Erwärmung (Joule Heating) bekannt. Es gelingt vorteilhaft, einen Energieeintrag zur Ausbildung einer Verbindung zwischen der Verschlusskappe und dem Substrat lokal stark zu begrenzen. Das Heizelement kann zweckmäßigerweise möglichst nahe an einer Grenzfläche zwischen Verschlusskappe und Substrat angeordnet sein. Dabei kann das Heizelement dem organischen Substrat und/oder der Verschlusskappe zugeordnet sein. Das Heizelement kann zum Aufschmelzen von gewünschten Bereichen der Verschlusskappe und/oder dem Substrat eingesetzt werden. Dabei können andere Verbindungsverfahren wie Löten, Ultraschallschweißen, Reibschweißen oder auch Kleben vollständig ersetzt werden. Denkbar ist jedoch auch, das Heizelement mit einem derartigen Verfahren zu kombinieren, wodurch der Energieeintrag in das Substrat etwa zum Löten oder Ultraschallschweißen stark herabgesetzt werden kann.

Vorteilhaft kann mit einer oder mehreren solcher Verschlusskappen ein auf organischen Substraten basierende hermetisch verschlossene Baugruppe, auch als Package bekannt, erzeugt werden. So genannte Packages dienen dazu, gewisse empfindliche Komponenten vor Umwelt- und/oder Prozesseinflüssen zu schützen, und sie werden oft auf eine Leiterplatte bei der Bestückung gelötet. Ein solches Package kann aus einem Basissubstrat, beispielsweise einer Leiterplatte, aktiven Komponenten, beispielsweise einem Halbleiterchip, und einer Abschlusskappe (Deckel) bestehen.

Verschiedene, insbesondere mikroelektronische Komponenten, wie etwa Hochfrequenz-Komponenten (HF-Komponenten) oder MEMS (MEMS = Micro-Electro-Mechanical Systems), sind dabei sehr feuchteempfindlich. Meist wird für solche Komponenten ein anorganisches Keramiksubstrat verwendet. Diese Keramiksubstrate lassen keine Diffusion von Wasser zu und sind gleichzeitig sehr temperaturbeständig. Die Abschlusskappe wird bei solchen Packages oft mit einem sehr hoch schmelzenden Lot verlötet.

Da diese anorganischen Substrate jedoch recht teuer sind, ist es, neben anderen Vorteilen, kosteneffizienter, organische Substrate zu verwenden. Gewisse organische Substrate, wie etwa LCP (LCP = Liquid Crystal Polymer), weisen eine sehr geringe Gasdiffusion auf und sind somit den anorganischen Substraten nahezu ebenbürtig und können somit ebenfalls für hermetische Packages verwendet werden. Dadurch, dass erfindungsgemäß die Abschlusskappe mit dem Substrat hermetisch verschlossen werden kann, ist es möglich, den Vorteil dieser wesentlich kostengünstigeren Materialien zu nutzen.

Selbstverständlich kann die Abdeckeinrichtung und das Verfahren zu dessen Herstellung auch dazu verwendet werden, auf einem Substrat, insbesondere einer Leiterplatte, bestimmte Bereiche mit einer Abschlusskappe hermetisch zu verschließen. Der Übergang zwischen beiden Fällen kann dabei, je nach Produkt, durchaus fließend sein.

Das Aufschmelzen der Materialien mittels eines Heizelements, beispielsweise eines Heizleiters, funktioniert für anorganische Substrate nicht, da diese erst bei einem Temperaturbereich erweichen oder schmelzen, der deutlich oberhalb dessen ist, was mit einem lokal angeordneten Heizelement, etwa einem Heizleiter, sinnvoll erreicht werden kann. Das gleiche gilt dabei auch für organische Duroplaste, d.h. Kunststoffe, bei denen der Schmelzpunkt höher ist als die Zersetzungstemperatur.

In den Fällen, wo ein Aufschmelzen der Materialien nicht möglich ist, kann erfindungsgemäß die notwendige Temperatur, die mit dem Heizelement erzeugt wird, für einen Löt- bzw. einen Klebprozess eingesetzt werden.

Grundsätzlich können auch mehrer abzudeckende Bereiche auf dem Substrat vorgesehen sein, die sich seriell oder günstigerweise auch parallel mit jeweils einer Verschlusskappe abgedeckt werden können, was für eine Massenfertigung vorteilhaft ist.

Die bereits erwähnten Packages unterscheiden sich insbesondere dadurch, dass sie typischerweise deutlich kleiner sind als ein Substrat in Form einer Leiterplatte. Es ist daher günstigerweise möglich, auf einem großen Produktionsrahmen viele Packages gleichzeitig zu prozessieren bzw. zu verschweißen und sie anschließend erst in einzelne Packages, bzw. Abdeckeinrichtungen, zu trennen.

Vorteilhaft kann das Heizelement eine Leiterbahn umfassen, die durch direkten Stromfluss erwärmbar ist. Durch Anlegen einer elektrischen Spannung über die Leiterbahn kann ein elektrischer Strom fließen, der durch Ohmsche Verluste zu einer entsprechend starken Temperaturerhöhung in der Leiterbahn und der Umgebung der Leiterbahn führt. Denkbar ist jedoch auch, das Heizelement alternativ durch Induktion und/oder Einkopplung hochfrequenter Strahlung zu erwärmen.

Bei einer Verwendung von geeigneten Strompulsen kann infolge der Wärmediffusion die Größe des erwärmten Bereiches gut kontrolliert werden. Durch das Einbringen von zusätzlichen Metallbereichen kann die Wärmediffusion gezielt beeinflusst werden, beispielsweise so, dass ein bestimmter Bereich sich möglichst homogen aufheizt.

Günstigerweise kann das Heizelement den abzudeckenden Bereich umgeben. Eine lokale Erwärmung kann um den ganzen abzudeckenden Bereich herum erfolgen. Denkbar ist jedoch auch, dass nur bereichsweise um den abzudeckenden Bereich ein Heizelement vorgesehen ist. Damit lassen sich lokale Verbindungen herstellen, falls erwünscht.

Das Heizelement kann mit einer Metallisierung abgedeckt sein. Dies ist günstig, wenn die Verschlusskappe aus Metall gebildet oder metallisiert ist, um eine Lötverbindung zwischen Verschlusskappe und Substrat auszubilden.

Gemäß einer günstigen Ausgestaltung kann das Heizelement des Substrats zugeordnet sein. Vorzugsweise kann das Heizelement auf dem Substrat angeordnet sein. Dies ist zweckmäßig, wenn die Verschlusskappe zumindest im verbindungsnahen Bereich aus einem Kunststoff, etwa einem Thermoplast, gebildet ist. Das Heizelement kann auch innerhalb des Substrats angeordnet sein. Es ist auch möglich ein Heizelement auf dem Substrat und ein Heizelement innerhalb des Substrats vorzusehen, welche in einem abzudeckenden Bereich zusammenwirken können, oder die für verschiedene abzudeckende Bereiche vorgesehen sind. Dies kann vorteilhaft an ein aktuelles Design des Substrats, etwa einer Leiterplatte, angepasst werden. Da eine Leiterplatte mehrlagige gedruckte Schaltungen aufweisen kann, kann das Heizelement einfach im Herstellprozess einer oder mehrerer Schaltungslagen der Leiterplatte mit gefertigt werden. Selbstverständlich kann auch ein Array von Heizelementen, für den Fall, dass mehr als ein abzudeckender Bereich mit einer Verschlusskappe ausgestattet werden soll, auf diese Weise gefertigt werden. Das Heizelement kann als elektrische Leiterbahn ausgebildet sein, deren Anschlusskontakte an einer Oberfläche des Substrats, z.B. der Leiterplatte, zugänglich sind.

Weiterhin kann das Heizelement der Verschlusskappe zugeordnet sein. Dabei kann dieses auf der Verschlusskappe angeordnet sein, insbesondere an Rändern der Verschlusskappe, mit denen die Verschlusskappe auf das Substrat aufgesetzt wird, oder das Heizelement kann innerhalb der Verschlusskappe angeordnet sein, oder es kann eine Kombination der beiden Möglichkeiten eingesetzt werden.

Die Verschlusskappe und das Substrat sind aus einem Thermoplasten gebildet. Handelt es sich bei dem Thermoplast um ein Material mit einer sehr geringen Wasser- und Gasdiffusion, insbesondere Liquid Crystal Polymer (LCP) so kann das Heizelement eine nahezu hermetisch dichte Verbindung zwischen der Verschlusskappe und dem Substrat bewirken, indem eine den abzudeckenden Bereich Schmelze erzeugt wird, die anschließend unter Bildung der Verbindung erstarrt.

Die Erfindung geht gemäß einem weiteren Aspekt aus von einem Verfahren zur Herstellung einer Abdeckeinrichtung.

Es werden Verfahrensschritte vorgeschlagen
- Bereitstellen eines organischen Substrats mit einem abzudeckenden Bereich mit einer Verbindungszone zwischen dem Substrat und einer Verschlusskappe, wobei die Verbindungszone wenigstens bereichsweise ein Heizelement aufweist;
- Aufsetzen der Verschlusskappe auf den abzudeckenden Bereich, wobei Ränder der Verschlusskappe mit einem Verlauf des Heizelements korrespondieren;
- Aktivieren des Heizelements zum Erwärmen der Verbindungszone; Herstellen einer Verbindung zwischen der Verschlusskappe und dem Substrat in der Verbindungszone.

Es kann vorteilhaft mit geeigneten Materialien (z.B. LCP) eine nahezu hermetisch dichte Verbindung hergestellt werden, wobei ein Energieeintrag nur lokal begrenzt in der Verbindungszone erfolgt. Das Aktivieren des Heizelements kann vorzugsweise durch Anlegen einer elektrischen Spannung über eine Leiterbahn erfolgen, welche einen Heizleiter bildet, oder auch mittels Induktion und/oder Einkopplung hochfrequenter Strahlung. Durch einen hohen Strompuls oder auch einen längeren Stromfluss kann die Verbindungszone, die sich in das Substrat und in der Verschlusskappe erstreckt, aufschmelzen. Beim Erstarren bildet sich eine (praktisch) hermetisch dichte Verbindung.

Gemäß einer günstigen Weiterbildung kann ein Aufbringen eines Lots vor dem Aufsetzen der Verschlusskappe zur Herstellung einer Lötverbindung zwischen Verschlusskappe und Substrat erfolgen. Dies ist vorteilhaft bei einer metallischen oder metallisierten Verschlusskappe zum Verlöten der Verschlusskappe mit dem Substrat. Alternativ kann ein Kleber vor dem Aufsetzen der Verschlusskappe zur Herstellung einer Klebeverbindung zwischen Verschlusskappe und Substrat aufgebracht werden, wobei der Kleber thermisch aktiviert wird.

Die Erfindung ist nachfolgend beispielhaft, anhand von in Zeichnungen dargestellten Ausführungsbeispielen, näher erläutert. Es zeigen:
- Fig. 1A, 1B: ein Ausführungsbeispiel einer erfindungsgemäßen Abdeckeinrichtung mit einer Verschlusskappe aus Kunststoff als Schnittansicht (Fig. 1A) und als Draufsicht (Fig. 1B);
- Fig. 2A-2C: Verfahrensschritte eines vorteilhaften Fügeverfahrens einer Abdeckeinrichtung nach Fig. 1A, 1B;
- Fig. 3A, 3B: eine Abdeckeinrichtung mit einer Verschlusskappe aus Metall als Schnittansicht (Fig. 3A) und als Draufsicht (Fig. 3B); und
- Fig. 4A-4D: Verfahrensschritte eines vorteilhaften Fügeverfahrens einer Abdeckeinrichtung nach Fig. 3A, 3B.

In den Figuren sind funktionell gleiche oder gleich wirkende Elemente jeweils mit denselben Bezugszeichen beziffert. Die Figuren sind schematische Darstellungen der Erfindung. Sie bilden nicht spezifische Parameter der Erfindung ab. Weiterhin geben die Figuren lediglich typischen Ausgestaltungen der Erfindung wieder und sollen die Erfindung nicht auf die dargestellten Ausgestaltungen beschränken.

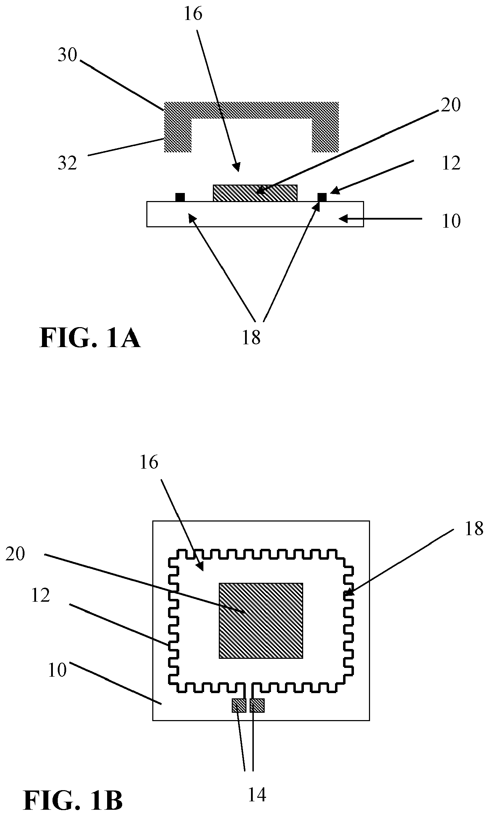

Fig. 1A und Fig. 1B zeigen in Schnittdarstellung mit abgehobener Verschlusskappe 30 und als Draufsicht ein Ausführungsbeispiel einer erfindungsgemäßen Abdeckeinrichtung mit der Verschlusskappe 30 aus Kunststoff, vorzugsweise einem Thermoplasten. Die Abdeckeinrichtung ist zum Abdecken eines Bereichs 16 eines beispielhaft als Leiterplatte ausgebildeten Substrats 10 vorgesehen und weist eine Verbindungszone 18 zwischen einer Verschlusskappe 30 und dem als Leiterplatte ausgebildeten Substrat 10 auf. Das als Leiterplatte ausgebildete Substrat 10 ist insbesondere ein so genanntes PCB (PCB = Printed Circuit Board) mit mikroelektronischen Schaltungen.

Die Verbindungszone 18 umfasst wenigstens bereichsweise ein Heizelement 12 zum Erwärmen der Verbindungszone 18 bei der Herstellung einer Verbindung zwischen Verschlusskappe 30 und als Leiterplatte ausgebildetem Substrat 10.

Der abzudeckende Bereich 16 enthält beispielweise eine Schaltung und/oder ein Bauelement 20, welches vorzugsweise hermetisch gegen die Umgebung gehäust werden soll. Selbstverständlich können mehrere solche abzudeckenden Bereiche auf dem als Leiterplatte ausgebildeten organischen Substrat 10 vorgesehen sein.

Im gezeigten Ausführungsbeispiel umgibt das Heizelement 12, das als Leiterbahn ausgeführt ist, welche einen Heizleiter bildet, den abzudeckenden Bereich 16 auf dem als Leiterplatte ausgebildeten organischen Substrat 10. Das als Leiterbahn ausgebildete Heizelement 12 ist durch direkten Stromfluss erwärmbar. Dazu kann an elektrische Kontakte 14, zwischen denen das als Leiterbahn ausgebildete Heizelement 12 angeordnet ist, eine elektrische Spannung angelegt werden. Als Heizleiter ist das als Leiterbahn ausgebildete Heizelement 12 relativ hochohmig, so dass sich das als Leiterbahn ausgebildete Heizelement 12 und dessen Umgebung schnell erwärmt.

Im vorliegenden Ausführungsbeispiel ist das Heizelement 12 auf dem als Leiterplatte ausgebildeten Substrat 10 angeordnet. Denkbar ist auch, dass ein Heizelement alternativ oder zusätzlich in der Verschlusskappe 30 vorgesehen ist. Dabei ist die Verschlusskappe 30 und/oder das als Leiterplatte ausgebildete Substrat 10 aus einem Kunststoff, insbesondere einem Thermoplast, gebildet, insbesondere einem nahezu hermetisch dichtem LCP-Material (LCP = Liquid Crystal Polymer).

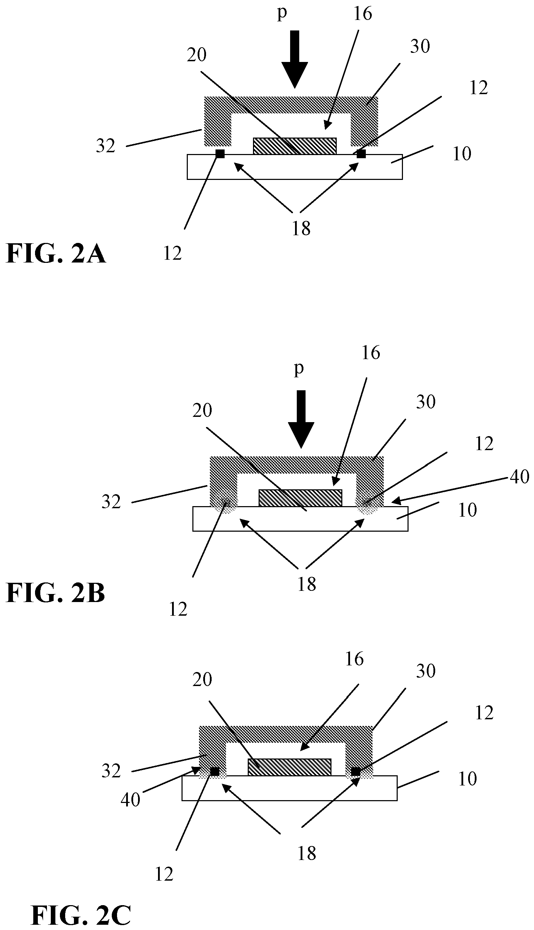

Die Fig. 2A-2C zeigen Verfahrensschritte eines vorteilhaften Fügeverfahrens einer Abdeckeinrichtung nach Fig. 1A, 1B.

Zunächst wird ein als Leiterplatte ausgebildetes organisches Substrat 10 mit einem abzudeckenden Bereich 16 mit einer Verbindungszone 18 zwischen dem als Leiterplatte ausgebildeten Substrat 10 und einer Verschlusskappe 30 bereitgestellt, wobei die Verbindungszone 18 wenigstens bereichsweise ein Heizelement 12 aufweist. Im vorliegenden Ausführungsbeispiel ist das Heizelement 12 als Leiterbahn ausgebildet, welche den abzudeckenden Bereich 16 als Heizleiter umgibt. Der abzudeckende Bereich 16 weist z.B. eine Schaltung oder ein Bauelement 20 auf (Fig. 2A).
Die Verschlusskappe 30 wird auf den abzudeckenden Bereich 16 mit einem Anpressdruck p aufgesetzt, wobei Ränder 32 der Verschlusskappe 30 mit einem Verlauf des Heizelements 12 korrespondieren. Die Ränder 32 setzen über dem als Leiterbahn ausgebildeten Heizelement 12 auf (Fig. 2B).
Anschließend erfolgt ein Aktivieren des Heizelements 12 zum Erwärmen der Verbindungszone 18 (Fig. 2C), wobei das als Leiterbahn ausgebildete Heizelement 12 bestromt wird und das Material der Verschlusskappe 30 und dem als Leiterplatte ausgebildeten Substrat 10 lokal in der Verbindungszone 18 aufschmilzt. Dadurch wird eine Verbindung 40 zwischen der Verschlusskappe 30 und dem als Leiterplatte ausgebildeten Substrat 10 in der Verbindungszone 18 hergestellt.

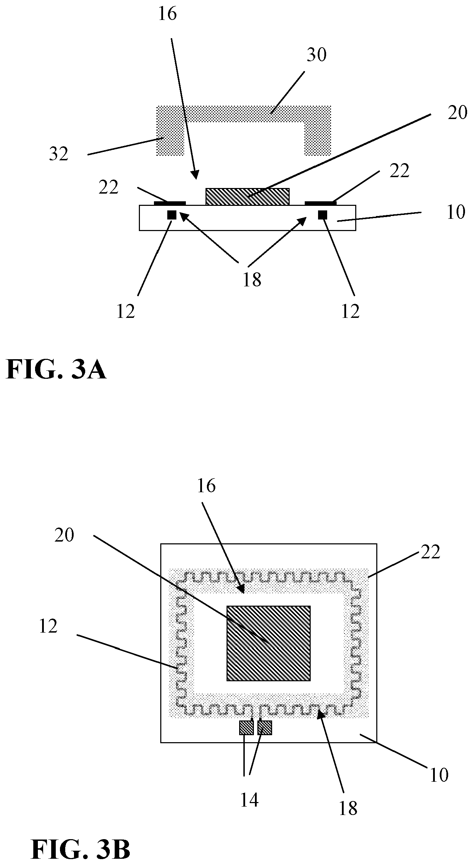

Fig. 3A, 3B illustriert eine Abdeckeinrichtung mit einer Verschlusskappe 30 aus Metall als Schnittansicht mit abgehobener Verschlusskappe 30 (Fig. 3A) und als Draufsicht (Fig. 3B). Das Heizelement 12 ist als Leiterbahn ausgebildet und innerhalb einem als Leiterplatte ausgebildeten Substrat 10 angeordnet, um einen Kurzschluss mit der Verschlusskappe 30 zu vermeiden. Beim Aufschmelzen des als Leiterplatte ausgebildeten Substrats 10 entsteht somit kein Kurzschluss zwischen metallischer Verschlusskappe 30 und Heizelement 12.
Über dem Heizelement 12 ist auf dem als Leiterplatte ausgebildeten Substrat 10 eine Metallisierung 22 vorgesehen. Elektrische Kontaktflächen 14 zur Kontaktierung des als Leiterbahn ausgebildeten Heizelements 12 können an die Oberfläche dem als Leiterplatte ausgebildeten Substrat 10 geführt sein.

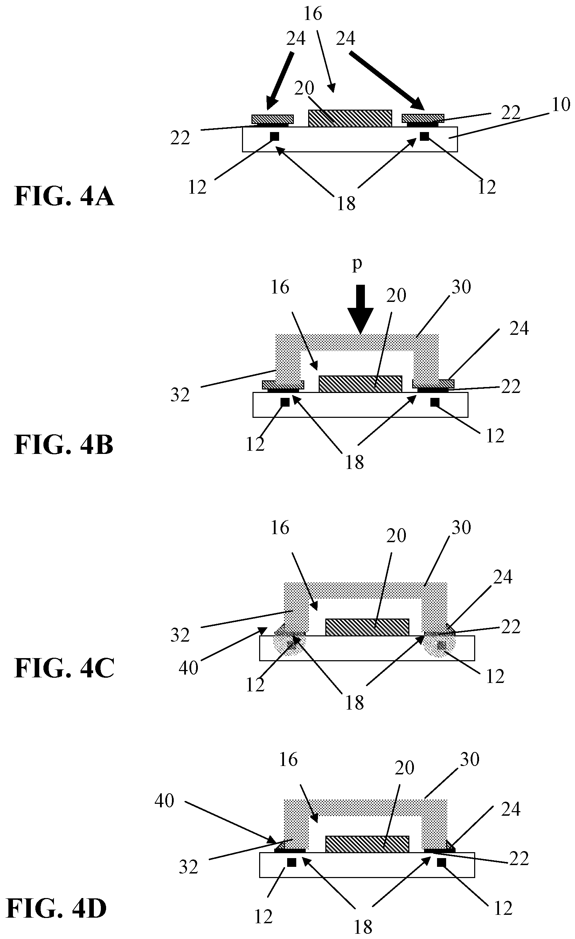

Fig. 4A-4D Verfahrensschritte eines vorteilhaften Fügeverfahrens einer Abdeckeinrichtung nach Fig. 3A, 3B.

Es wird eine als Leiterplatte ausgebildetes organisches Substrat 10 bereitgestellt mit einem abzudeckenden Bereich 16 mit einer Verbindungszone 18 zwischen dem als Leiterplatte ausgebildeten Substrat 10 und einer Verschlusskappe 30, wobei die Verbindungszone 18 wenigstens bereichsweise ein Heizelement 12 aufweist (Fig. 4A). Dabei ist das als Leiterbahn ausgebildete Heizelement 12 innerhalb dem als Leiterplatte ausgebildeten Substrat 10 angeordnet. Eine Metallisierung 22 ist über dem als Leiterbahn ausgebildeten Heizelement 12 vorgesehen, über welcher vor dem Aufsetzen der Verschlusskappe 30 ein Lot 24 aufgetragen wird.

Das Aufsetzen der Verschlusskappe 30 auf den abzudeckenden Bereich 16 erfolgt unter einem ausreichenden Anpressdruck p, wobei Ränder 32 der Verschlusskappe 30 mit einem Verlauf des Heizelements 12 korrespondieren und über diesem angeordnet sind (Fig. 4B).

Durch Aktivieren des Heizelements 12 zum Erwärmen der Verbindungszone 18 wird das Lot 24 geschmolzen, welches die Ränder 32 der Verschlusskappe 30 und die Metallisierung 22 auf dem als Leiterplatte ausgebildeten Substrat 10 benetzt (Fig. 4C) und nach Erstarren eine hermetisch dichte Verbindung 40 zwischen der Verschlusskappe 30 und dem als Leiterplatte ausgebildeten Substrat 10 in der Verbindungszone 18 ausbildet (Fig. 4D).

Denkbar ist auch, Lot 24 zusätzlich oder alternativ auf die Kontaktflächen der Ränder 32 der Verschlusskappe 30 aufzutragen, mit denen die Verschlusskappe 30 auf das als Leiterplatte ausgebildete Substrat 10 gesetzt wird.

Sinngemäß kann das Ausführungsbeispiel der Fig. 3A, 3B und 4A-4D auch zur Illustration der Herstellung einer Klebeverbindung zwischen der Verschlusskappe 30 und dem als Leiterplatte ausgebildeten Substrat 10 herangezogen werden, wobei das Lot 24 durch eine thermisch aktivierbare Kleberschicht ersetzt wird.

## Patentansprüche

1. Abdeckeinrichtung zum Abdecken eines Bereichs (16) einem als PCB ausgebildeten organischen Substrat (10), mit einer Verbindungszone (18) zwischen einer Verschlusskappe (30) und dem Substrat (10), wobei
- die Verbindungszone (18) wenigstens bereichsweise ein Heizelement (12) zum Erwärmen der Verbindungszone (18) bei der Herstellung einer Verbindung (40) zwischen Verschlusskappe (30) und Substrat (10) umfasst, wobei das Heizelement (12) eine Leiterbahn umfasst, die durch direkten Stromfluss erwärmbar ist;
- die Verschlusskappe (30) und das Substrat (10) aus einem Thermoplast gebildet ist, und
- der abzudeckende Bereich (16) eine Schaltung und/oder ein Bauelement (20) enthält;
**dadurch gekennzeichnet, dass** eine Verbindung (40) zwischen der Verschlusskappe (30) und dem als Leiterplatte ausgebildeten Substrat (10) in der Verbindungszone (18) hergestellt ist, indem durch Aktivieren des Heizelements 12 zum Erwärmen der Verbindungszone 18 das Material der Verschlusskappe 30 und das des als Leiterplatte ausgebildeten Substrats (10) lokal in der Verbindungszone (18) aufschmilzt.

2. Abdeckeinrichtung nach Anspruch 1, **dadurch gekennzeichnet, dass** das Heizelement (12) durch Induktion und/oder RF Einkopplung erwärmbar ist

3. Abdeckeinrichtung nach Anspruch 1, **dadurch gekennzeichnet, dass** das Heizelement (12) den abzudeckenden Bereich (16) umgibt.

4. Abdeckeinrichtung nach einem der vorhergehenden Ansprüche, **dadurch gekennzeichnet, dass** das Heizelement (12) mit einer Metallisierung (22) abgedeckt ist.

5. Abdeckeinrichtung nach einem der vorhergehenden Ansprüche, **dadurch gekennzeichnet, dass** das Heizelement (12) dem Substrat (10) zugeordnet ist.

6. Abdeckeinrichtung nach Anspruch 5, **dadurch gekennzeichnet, dass** das Heizelement (12) auf dem Substrat (10) angeordnet ist.

7. Abdeckeinrichtung nach Anspruch 5, **dadurch gekennzeichnet, dass** das Heizelement (12) innerhalb des Substrats (10) angeordnet ist.

8. Abdeckeinrichtung nach einem der Ansprüche 1 bis 3, **dadurch gekennzeichnet, dass** das Heizelement (12) der Verschlusskappe (30) zugeordnet ist.

9. Verfahren zur Herstellung einer Abdeckeinrichtung nach einem der Ansprüche 1 bis 8, **gekennzeichnet durch**
- Bereitstellen eines organischen Substrats (10) mit einem abzudeckenden Bereich (16) mit einer Verbindungszone (18) zwischen dem Substrat (10) und einer Verschlusskappe (30), wobei die Verbindungszone (18) wenigstens bereichsweise ein Heizelement (12) aufweist;
- Aufsetzen der Verschlusskappe (30) auf den abzudeckenden Bereich (16), wobei Ränder (32) der Verschlusskappe (30) mit einem Verlauf des Heizelements (12) korrespondieren;
- Aktivieren des Heizelements (12) zum Erwärmen der Verbindungszone (18);
- Herstellen einer Verbindung (40) zwischen der Verschlusskappe (30) und dem Substrat (10) in der Verbindungszone (18).

10. Verfahren nach Anspruch 9 , **gekennzeichnet durch** Aufbringen eines Lots (24) vor dem Aufsetzen der Verschlusskappe (30) zur Herstellung einer Lötverbindung zwischen Verschlusskappe (30) und Substrat (10).

11. Verfahren nach Anspruch 9 , **gekennzeichnet durch** Aufbringen eines Klebers vor dem Aufsetzen der Verschlusskappe (30) zur Herstellung einer Klebeverbindung zwischen Verschlusskappe (30) und Substrat (10).

## Claims

1. A covering device for covering a region (16) of an organic substrate (10) formed as a PCB, with a connecting zone (18) between a closure cap (30) and the substrate (10), wherein
- the connecting zone (18) comprises, at least in some regions, a heating element (12) for heating the connecting zone (18) during production of a connection (40) between closure cap (30) and substrate (10), wherein the heating element (12) comprises a conducting track, which can be heated by direct current flow;
- the closure cap (30) and the substrate (10) are formed from a thermoplastic, and
- the region (16) to be covered contains a circuit and/or a component (20);
**characterised in that** a connection (40) is produced in the connecting zone (18) between the closure cap (30) and the substrate (10) formed as a printed circuit board **in that** the material of the closure cap 30 and the material of the substrate (10) formed as a printed circuit board is melted locally in the connecting zone (18) by activating the heating element 12 to heat the connecting zone 18.

2. The covering element according to claim 1, **characterised in that** the heating element (12) can be heated by induction and/or RF coupling.

3. The covering element according to claim 1, **characterised in that** the heating element (12) surrounds the region (16) to be covered.

4. The covering element according to any one of the preceding claims, **characterised in that** the heating element (12) is covered by a metallisation (22).

5. The covering element according to any one of the preceding claims, **characterised in that** the heating element (12) is associated with the substrate (10).

6. The covering element according to claim 5, **characterised in that** the heating element (12) is arranged on the substrate (10).

7. The covering element according to claim 5, **characterised in that** the heating element (12) is arranged within the substrate (10).

8. The covering element according to any one of claims 1 to 3, **characterised in that** the heating element (12) is associated with the closure cap (30).

9. A method for producing a covering device according to any one of claims 1 to 8, **characterised by**
- providing an organic substrate (10) with a region that is to be covered (16) with a connecting zone (18) between the substrate (10) and a closure cap (30), wherein the connecting zone (18) has a heating element (12) at least in some regions;
- placing the closure cap (30) on the region (16) that is to be covered, wherein edges (32) of the closure cap (30) correspond to a course of the heating element (12);
- activating the heating element (12) to heat the connecting zone (18);
- producing a connection (40) between the closure cap (30) and the substrate (10) in the connecting zone (18).

10. The method according to claim 9, **characterised by** applying a solder (24) before the closure cap (30) is placed in position so as to produce a solder connection between closure cap (30) and substrate (10).

11. The method according to claim 9, **characterised by** applying an adhesive before the closure cap (30) is placed in position so as to produce an adhesive bond between closure cap (30) and substrate (10).

## Revendications

1. Dispositif de recouvrement pour le recouvrement d'une région (16) d'un substrat (10) organique conçu sous la forme d'un circuit imprimé PCB, avec une zone de liaison (18) entre un capuchon de fermeture (30) et le substrat (10), où
- la zone de liaison (18) comprend au moins sur des portions un élément chauffant (12) pour le réchauffement de la zone de liaison (18) lors de l'établissement d'une liaison (40) entre le capuchon de fermeture (30) et le substrat (10), où l'élément chauffant (12) comprend une bande conductrice qui peut être réchauffée par un courant direct ;
- le capuchon de fermeture (30) et le substrat (10) sont constitués d'un thermoplastique, et
- la région (16) à recouvrir contient un commutateur et/ou un composant (20) ;
**caractérisé en ce que** la liaison (40) entre le capuchon de fermeture (30) et le substrat (10) conçu sous forme de carte de circuit imprimé est édifiée dans la zone de liaison (18), par le fait que, par l'activation de l'élément chauffant 12 pour le réchauffement de la zone de liaison 18, le matériau du capuchon de fermeture 30 et celui du substrat (10) conçu sous la forme de carte de circuit imprimé fond localement dans la zone de liaison (18).

2. Dispositif de recouvrement selon la revendication 1, **caractérisé en ce que** l'élément chauffant (12) peut être réchauffé par induction et/ou par couplage de radiofréquences RF.

3. Dispositif de recouvrement selon la revendication 1, **caractérisé en ce que** l'élément chauffant (12) entoure la région (16) à recouvrir.

4. Dispositif de recouvrement selon l'une des revendications précédentes, **caractérisé en ce que** l'élément chauffant (12) est recouvert d'une métallisation (22).

5. Dispositif de recouvrement selon l'une des revendications précédentes, **caractérisé en ce que** l'élément chauffant (12) est associé au substrat (10).

6. Dispositif de recouvrement selon la revendication 5, **caractérisé en ce que** l'élément chauffant (12) est disposé sur le substrat (10).

7. Dispositif de recouvrement selon la revendication 5, **caractérisé en ce que** l'élément chauffant (12) est disposé à l'intérieur du substrat (10).

8. Dispositif de recouvrement selon l'une des revendications 1 à 3, **caractérisé en ce que** l'élément chauffant (12) est associé avec le capuchon de fermeture (30).

9. Procédé de réalisation d'un dispositif de recouvrement selon l'une des revendications 1 à 8, **caractérisé par**
- la mise au point d'un substrat (10) organique avec une région (16) à recouvrir, avec une zone de liaison (18) entre le substrat (10) et un capuchon de fermeture (30), où la zone de liaison (18) présente un élément chauffant (12) au moins sur des sections ;
- la mise en place d'un capuchon de fermeture (30) sur la région (16) à recouvrir, où les bords (32) du capuchon de fermeture (30) correspondent à une évolution de l'élément chauffant (12) ;
- l'activation de l'élément chauffant (12) pour le réchauffement de la zone de liaison (18) ;
- la réalisation d'une liaison (40) entre le capuchon de fermeture (30) et le substrat (10) dans la zone de liaison (18).

10. Procédé selon la revendication 9, **caractérisé par** l'application d'une soudure (24) avant la mise en place du capuchon de fermeture (30) pour la réalisation d'une liaison par soudure entre le capuchon de fermeture (30) et le substrat (10).

11. Procédé selon la revendication 9, **caractérisé par** l'application d'une colle avant la mise en place du capuchon de fermeture (30) pour la réalisation de la liaison par collage entre le capuchon de fermeture (30) et le substrat (10).
